# EUROPÄISCHE PATENTSCHRIFT

(11) **EP 2 176 087 B1**
(45) Veröffentlichungstag und Bekanntmachung des Hinweises auf die Patenterteilung: **01.12.2010**
(21) Anmeldenummer: 08758712.7
(22) Anmeldetag: 16.05.2008
(51) Int. Cl.: B60K 37/06, B60R 11/02

(54) **BERÜHRUNGSLOS MESSENDE POSITIONSBESTIMMUNGSEINHEIT UND VERFAHREN ZUM BERÜHRUNGSLOSEN BESTIMMEN EINER POSITION EINES BETÄTIGUNGSELEMENTS EINES NUTZERS EINES KRAFTFAHRZEUGS**
POSITION-DETERMINING UNIT WHICH MEASURES IN A CONTACTLESS FASHION AND METHOD FOR THE CONTACTLESS DETERMINATION OF A POSITION OF AN ACTIVATION ELEMENT OF A USER OF A MOTOR VEHICLE
UNITE DE DETERMINATION DE POSITION PAR MESURE SANS CONTACT ET PROCEDE DE DETERMINATION SANS CONTACT DE LA POSITION D'UN ELEMENT D'ACTIONNEMENT D'UN UTILISATEUR D'UN VEHICULE AUTOMOBILE

(30) Priorität: 10.07.2007 DE 102007032472
(43) Veröffentlichungstag der Anmeldung: 21.04.2010
(73) Patentinhaber: Volkswagen AG, 38436 Wolfsburg (DE)
(72) Erfinder: BACHFISCHER, Katharina, 40476 Düsseldorf (DE); BENDEWALD, Lennart, 38442 Wolfsburg (DE); VIKOLER, Peter, 39042 Brixen (DE); WÄLLER, Christoph, 38102 Braunschweig (DE)
(74) Vertreter: Obst, Bernhard
(86) Internationale Anmeldenummer: PCT/EP2008/004115
(87) Internationale Veröffentlichungsnummer: WO 2009/006968

(56) Entgegenhaltungen:
- WO-A-2004/025062
- GB-A- 2 428 094

## Beschreibung

Berührungslos messende Positionsbestimmungseinheit und Verfahren zum berührungslosen Bestimmen einer Position eines Betätigungselements eines Nutzers eines Kraftfahrzeugs

Die Erfindung betrifft eine berührungslos messende Positionsbestimmungseinheit sowie ein Verfahren zum berührungslosen Bestimmen einer Position eines Betätigungselements eines Nutzers eines Kraftfahrzeugs im Raum. Insbesondere betrifft die Erfindung eine Positionsbestimmungseinheit und ein Verfahren, bei dem ein hochfrequentes Gebersignal mit einem Sendepegel erzeugt und kapazitiv, gegebenenfalls auch leitend, in einen Nutzer eingekoppelt wird. Das Gebersignal wird über den Nutzer und ein Betätigungselement des Nutzers, beispielsweise einen Finger, übertragen und kapazitiv von mehreren zueinander beabstandet angeordneten Sensoren empfangen. Eine empfangene Signalstärke wird von jedem Sensor mittels eines Sensorpegels angegeben. Mittels einer Steuer- und Auswerteeinheit wird aus den von den mehreren Sensoren bereitgestellten Sensorpegeln unter Berücksichtigung der vorbekannten Positionen der Sensoren eine Position des Betätigungselements des Nutzers im Raum ermittelt.

Positionsbestimmungseinheiten und Verfahren zum berührungslosen Bestimmen der Position sind aus dem Stand der Technik bekannt.

Beispielsweise beschreibt die WO 2004/078536 die grundlegende Technologie zum Übertragen von hochfrequenten Signalen über einen Körper eines Nutzers und eine kapazitive Erfassung des übertragenen Signals mittels eines Sensors. Hierbei ist eine Ausführungsform beschrieben, bei der ein Sender in einen Fahrzeugsitz integriert ist und ein hochfrequentes Signal, welches vorzugsweise moduliert ist, in den Nutzer kapazitiv einkoppelt. Das kapazitiv von einem Sensor empfangene Signal zeigt eine Annäherung des Betätigungselements an den Sensor an. Anhand der übertragenen Signalstärke kann auf einen Abstand des Betätigungselements von dem Sensor zurückgeschlossen werden. GB 2 428094 A beschreibt eine gattungsgemäße Einheit nach dem Oberbegriff des Anspruchs 1. Nutzt man mehrere dieser Sensoren, so kann über eine Triangulation anhand von Sensorpegeln, die jeweils die empfangene Signalstärke des übertragenen Hochfrequenzsignals angeben, kann eine Position des Betätigungselements im Raum bestimmt werden, sofern die Positionen der einzelnen empfangenen Sensoren vorbekannt sind.

Positionsbestimmungseinheiten, die berührungslos die Position eines Betätigungselements eines Nutzers erfassen und bestimmen können, können in der Zukunft beispielsweise eingesetzt werden, um eine komfortablere Steuerung von Benutzerschnittstellen im Kraftfahrzeug zu ermöglichen. Insbesondere Benutzerschnittstellen, die eine Anzeigefläche umfassen, auf der Informationen ähnlich wie bei einem Touchscreen dargestellt werden, können vorteilhaft mit einer solchen Positionsbestimmungseinheit verwendet werden.

Um eine Position des Betätigungselements möglichst exakt in einem bestimmten Raumbereich, beispielsweise in einem Volumen vor einer Anzeigefläche, bestimmen zu können, ist es vorteilhaft, wenn das Betätigungselement nur innerhalb dieses für eine Wechselwirkung vorgesehene Volumen erfasst wird und zugleich innerhalb dieses Volumens eine möglichst große Sensorpegeldynamik aufweist. Dies bedeutet, dass die einzelnen Sensorpegel in Abhängigkeit von der Position des Betätigungselements innerhalb des Volumens zwischen den Maximalwerten schwanken sollen. Bei günstigen Übertragungsbedingungen ist die an den Sensoren empfangene Signalstärke häufig so groß, dass sich der Sensorpegel ab einem bestimmten Abstand von den einzelnen Sensoren bei einer weiteren Annäherung nicht mehr ändert. Die empfangene Signalstärke liegt in einem solchen Fall außerhalb des Arbeitsbereichs des empfangenen Sensors. Ist hingegen die empfangene Signalstärke zu gering, so ist die mit einer Ortsänderung des Betätigungselements verknüpfte Sensorpegeländerung zu gering, um eine sinnvolle Ortsauflösung zu ermöglichen oder das Betätigungselement wird erst ab einem sehr geringen Abstand von den einzelnen Sensoren erfasst, so dass das Betätigungselement nicht mehr von allen Sensoren im gesamten Volumenbereich erfasst wird, in dem die Position des Betätigungselements ermittelt werden soll. Eine zuverlässige Positionsbestimmung in dem Volumen ist jedoch nur möglich, wenn das Betätigungselement zeitgleich an jedem Ort von mindestens drei Sensoren erfasst wird, um eine Triangulation zu ermöglichen. Ist somit die empfangene Signalstärke zu gering, ist eine zuverlässige Ermittlung der Position des Betätigungselements in dem Volumen nicht mehr gewährleistet.

Die empfangene Signalstärke hängt u.a. davon ab, welche Leitfähigkeit der einzelne Nutzer, der zur Übertragung der Hochfrequenzsignale verwendet wird, aufweist. Diese Leitfähigkeit ist u.a. von dessen Kleidung und physiologischen Körperzuständen abhängig, beispielsweise einer Schweißproduktion, die eine Oberflächenleitfähigkeit der Körperoberfläche steigert. Ferner spielt die geometrische Gestalt des Betätigungselements ebenfalls eine Rolle, da von dieser eine kapazitive Kopplung an die Sensoren beeinflusst ist. Ist das Betätigungselement ein Finger, so hängt die kapazitive Kopplung von der Haltung der übrigen Finger, d.h. einer Handhaltung, ab.

Der Erfindung liegt somit die technische Aufgabe zugrunde, eine berührungslos messende Positionsbestimmungseinheit sowie ein Verfahren zum berührungslosen Bestimmen einer Position eines Betätigungselements eines Nutzers in einem Kraftfahrzeug zu schaffen, mit denen jeweils eine gute Ortsauflösung und zuverlässige Positionsbestimmung in einem vorgegebenen Messvolumen realisierbar ist.

Die Aufgabe wird erfindungsgemäß durch eine berührungslos messende Positionsbestimmungseinheit mit den Merkmalen des Patentanspruchs 1 sowie ein Verfahren zum berührungslosen Bestimmen einer Position eines Betätigungselements eines Nutzers eines Kraftfahrzeugs im Raum mit den Merkmalen des Patentanspruchs 8 gelöst. Vorteilhafte Ausgestaltungen der Erfindung ergeben sich aus den Unteransprüchen.

Die Erfindung basiert auf dem Grundgedanken, dass eine von den einzelnen Sensoren empfangene Signalstärke vorzugsweise nur von der Position des Betätigungselements und ansonsten von keinen weiteren Faktoren abhängig sein sollte. Hierbei wird davon ausgegangen, dass die einzelnen Sensoren der Positionsbestimmungseinheit hinsichtlich der von ihnen bereitgestellten Sensorpegel kalibriert sind. Dies bedeutet, dass ein Zusammenhang zwischen den bereitgestellten relativen Sensorpegeln, d.h. den empfangenen relativen Signalstärken des über den Nutzer und dessen Betätigungselement übertragenen Hochfrequenzsignals, und einem Abstand relativ zu den Sensoren bekannt ist. Ein Sensorpegel kann somit für jeden der Sensoren in einen Abstand umgewandelt werden. Um bei unterschiedlichen Übertragungsbedingungen von einem Signalgeber zu den einzelnen Sensoren jeweils möglichst eine identische übertragene Signalstärke in Abhängigkeit von dem Abstand des Betätigungselements von dem jeweiligen Sensor zu erhalten, ist somit erfindungsgemäß vorgesehen, das von dem Signalgeber erzeugte Gebersignal hinsichtlich eines bereitgestellten Sendepegels anzupassen. Insbesondere wird somit eine berührungslos messende Positionsbestimmungseinheit vorgeschlagen, die einen Signalgeber, der ausgebildet ist, ein hochfrequentes Gebersignal mit einem Sendepegel zu erzeugen und kapazitiv oder leitend in einen Nutzer einzukoppeln, mehrere zueinander beabstandete Sensoren, die ausgebildet sind, das über den Nutzer und ein Betätigungselement des Nutzers übertragene Gebersignal kapazitiv zu erfassen, und eine Steuer- und Auswerteeinheit umfasst, die anhand der von den Einzelnen der mehreren Sensoren bereitgestellten Sensorpegeln, die jeweils eine empfangene Gebersignalstärke repräsentieren, unter Berücksichtigung der vorbekannten Positionen der Sensoren eine Position des Betätigungselements des Nutzers im Raum bestimmt, wobei der Signalgeber mit der Steuer- und Auswerteeinheit informationstechnisch gekoppelt ist und ausgebildet ist, den Sendepegel des Gebersignals in Abhängigkeit von von der Steuer- und Auswerteeinheit empfangenen Steuerinformationen anzupassen. Erfindungsgemäß sind somit folgende Schritte vorgesehen: Erzeugen eines hochfrequenten Gebersignals mit einem Sendepegel mittels eines Signalgebers und kapazitives oder leitendes Einkoppeln des Gebersignals in den Nutzer, Empfangen des über den Nutzer und ein Betätigungselement des Nutzers übertragenen und kapazitiv in mehreren zueinander beabstandet angeordneten Sensoren eingekoppelten Gebersignals, wobei jeder Sensor ein einen Sensorpegel repräsentierendes Signal bereitstellt, wobei der Sensorpegel jeweils eine empfangene Gebersignalstärke repräsentiert, und mittels einer Steuer- und Auswerteeinheit anhand der von den mehreren Sensoren bereitgestellten Sensorpegeln unter Berücksichtigung der vorbekannten Positionen der Sensoren eine Position des Betätigungselements des Nutzers im Raum ermittelt wird, wobei die Steuer- und Auswerteeinheit Steuerinformationen zu dem Signalgeber übermittelt und der Signalgeber den Sendepegel des Gebersignals entsprechend der Steuerinformationen anpasst. Durch ein Anpassen des Sendepegels in Abhängigkeit von den empfangenen Signalstärken, welche in den Sensorpegeln repräsentiert sind, wird erreicht, dass die einzelnen Sensoren jeweils mit einer maximalen Dynamik innerhalb des für die Detektion des Betätigungselements vorgesehenen Volumens arbeiten können. Hierbei muss lediglich eine Signalstärke, nämlich die von dem Signalgeber bereitgestellte Signalstärke des Gebersignals angepasst werden. Eine Anpassung der an den einzelnen Sensoren empfangsseitig angeordneten Verstärkereinheiten oder einer Sensorempfindlichkeit der einzelnen Sensoren kann hierbei unterbleiben. Dies bietet den Vorteil, dass eine Kalibration der Positionsbestimmungseinheit, mittels derer die einzelnen relativen Sensorpegel in Positionen im Raum umgerechnet werden können, unverändert bleibt.

Als vorteilhaft hat es sich erwiesen, die einzelnen Sensorpegel für eine Position zu erfassen, die der Positionsbestimmungseinheit bekannt ist. Bei einer bevorzugten Ausführungsform ist daher vorgesehen, dass ein Bedienelement mit der Auswerte- und Steuereinheit gekoppelt ist, mit dem eine Betätigungshandlung des Betätigungselements zeitlich korreliert mit den die empfangenen Signalgeberstärken im Betätigungszeitpunkt repräsentierenden Sensorpegeln erfassbar ist und die Steuerinformationen aus diesen Sensorpegeln abgeleitet werden. Die Position des Bedienelements ist vorbekannt. Werden die Sensorpegel zeitlich korreliert mit dem Betätigungszeitpunkt des Bedienelements erfasst, so sind sowohl die Sensorpegel als auch die Position des Betätigungselements zu einem Zeitpunkt bekannt. Hierbei wird davon ausgegangen, dass das Bedienelement in dem von der Positionsbestimmungseinheit überwachten Volumen liegt oder direkt an dieses Volumen angrenzt. Für die vorbekannte Position, an der sich das Bedienelement befindet, kann für jeden Sensor ein Sollsensorpegel oder Sollsensorpegelbereich festgelegt sein, der von dem entsprechenden Sensor erzeugt werden soll, wenn das Betätigungselement das Bedienelement betätigt, d.h. sich an der vorbekannten Position befindet. Existieren für einen oder mehrere Sensoren Abweichungen, so ist eine entsprechende Sendepegelanpassung vorteilhaft.

Als vorteilhaft hat es sich erwiesen, wenn das Bedienelement ein Touchscreen ist, der zusätzlich zu einer Information, die einen Berührzeitpunkt angibt, auch eine Berührpositionsinformation bereitstellt. Ein so ausgebildetes Bedienelement ermöglicht es, bei jeder Betätigungshandlung des Touchscreens eine Überprüfung der einzelnen Sensorpegel hinsichtlich einer Vorgabe bezüglich des entsprechenden Berührortes auszuführen und entsprechend den Sendepegel anzupassen. Dieses ist insbesondere dann von Vorteil, wenn der Nutzer während einer längeren Fahrt seine Sitzposition verändert und/oder sich der physiologische Zustand des Körpers, beispielsweise aufgrund von Hitzeeinwirkung, verändert. Die Sitzposition hat insbesondere dann einen Einfluss auf die von den einzelnen Sensoren empfangene Signalstärke, wenn der Signalgeber in den Fahrzeugsitz integriert ist.

Um Situationen zu verhindern, in denen eine Annäherung an einen der Sensoren nicht korrekt erfasst wird, da dieser bereits bei einem endlichen Abstand des Betätigungselements von dem entsprechenden Sensor einen Sensorpegel bereitstellt, der eine maximal empfangbare Gebersignalstärke repräsentiert, ist bei einer bevorzugten Ausführungsform der Erfindung vorgesehen, dass für jeden Sensor eine Pegelschwelle festgelegt ist und die Steuerinformationen verändert werden, wenn einer der Sensorpegel die zugehörige Pegelschwelle überschreitet. Hierbei wird davon ausgegangen, dass der Sensorpegel mit einer Zunahme der empfangenen Signalstärke ansteigt. Dies bedeutet, dass ein Sensor einen maximalen Sensorpegel ausgibt, wenn das Betätigungselement einen minimal möglichen Abstand zu dem Sensor aufweist. Ist somit der Sendepegel, mit dem das Gebersignal in den Nutzer eingekoppelt wird, so groß, dass einer der Sensoren eine Gebersignalstärke empfängt, die außerhalb des vorgesehenen Arbeitsbereichs liegt, wird bei der bevorzugten Ausführungsform der Sendepegel des Gebersignals reduziert, um hierüber auch eine Reduktion der empfangenen Gebersignalstärke bei dem entsprechenden Sensor zu veranlassen, so dass die empfangene Gebersignalstärke wieder im Arbeitsbereich des entsprechenden Sensors liegt.

Um sicherzustellen, dass eine Annäherung des Betätigungselements zuverlässig erkannt wird, d.h. ein Eindringen des Betätigungselements in das zu überwachende Volumen zuverlässig erfasst wird, kann bei einer Ausführungsform vorgesehen sein, dass der Sendepegel bei einer Inbetriebnahme auf einen Maximalsendepegel angepasst wird und die Steuer- und Auswerteeinheit die Steuerinformationen so erzeugt, dass der Sendepegel angepasst wird, um die Sensorpegel innerhalb ihres vorfestgelegten Pegelwertebereichs zu halten, während das Betätigungselement erstmals in Berührung mit dem Bedienelement gebracht wird. Wird beispielsweise eine der für jeden der Sensoren festgelegten Pegelschwellen durch den entsprechenden Sensorpegel überschritten, so wird der Sendepegel des Gebersignals reduziert. Zwar ist in einem solchen Fall eine absolute Positionsbestimmung in dem überwachten Volumen während einer ersten Annäherung des Betätigungselements nur unzureichend oder gar nicht möglich, dafür ist aber in der Regel die optimale Sendepegeleinstellung bereits in dem Moment erreicht, in dem das Betätigungselement das Bedienelement betätigt, sofern die Pegelschwelle bezogen auf die Berührposition des Betätigungselements richtig gewählt ist.

Bei anderen Ausführungsformen kann vorgesehen sein, dass auch im weiteren Betrieb der Sendepegel jeweils dann angepasst wird, in der Regel reduziert wird, wenn einer der Sensorpegel einen ihm zugeordneten Pegelwertbereich zu verlassen droht oder verlässt.

Um jedoch zu verhindern, dass in solchen Situationen, in denen aufgrund einer Störung die empfangene Gebersignalstärke kurzfristig ausnahmsweise sehr hoch ist und zu einer Anpassung (Reduzierung) des Sendepegels führt, die anschließend den verwendbaren Arbeitsbereich stark einschränkt oder sogar dazu führt, dass ein innerhalb des zu überwachenden Volumens befindliches Betätigungselement gar nicht von den Sensoren erfasst werden kann, ist bei einer bevorzugten Weiterbildung der Erfindung vorgesehen, dass der Sendepegel des Gebersignals nach einem Berühren des Bedienelements bis zu einem Sendepegelschwellenwert wieder angehoben wird, wenn die Sensorpegel aller Sensoren außerhalb der vorfestgelegten Pegelwertebereiche liegen und der Sendepegel bei einer erneuten Annäherung des Betätigungselements an das Bedienelement erneut abgesenkt wird, um die Sensorpegel in dem Pegelwertebereich zu halten. Der Sendepegel des Gebersignals wird somit nach einem Berühren, insbesondere einem erstmaligen Berühren, des Bedienelements über einen vorgegebenen Zeitraum bis zu einem Sendepegelschwellenwert wieder angehoben, wenn die Sensorpegel alle außerhalb des vorfestgelegten Pegelbereichs liegen (d.h., das Betätigungselement nicht in dem überwachten Volumen detektiert wird), und ferner wird der Sendepegel des Gebersignals bei einer erneuten Annäherung erneut abgesenkt, um die Sensorpegel in dem Pegelbereich zu halten. Über das Steigern des Sendepegels wird die Empfindlichkeit der einzelnen Sensoren hinsichtlich einer Annäherung gesteigert. Somit wird das Betätigungselement bereits in einem größeren Abstand erfasst. Situationen, in denen der Sendepegel aufgrund von Störungen bei einer Annäherung an das Bedienelement einmal zu stark abgesenkt wurde und dazu führen, dass bei normalen Bedingungen das Betätigungselement nicht korrekt erfasst wird, werden hierdurch vermieden.

Geht man davon aus, ein Nutzer unmittelbar nach einem Einstieg in ein Kraftfahrzeug keine unmittelbare Bedienabsicht hinsichtlich des Bedienelements besitzt und somit sein Betätigungselement noch nicht in einen überwachten Volumenbereich, innerhalb dessen das Betätigungselement erfasst werden soll, bewegt hat, so erweist sich eine Ausführungsform als vorteilhaft, bei der mit der Steuer- und Auswerteeinheit Mittel zum Erfassen eines Einstiegs des Nutzers verknüpft sind, und die Steuerinformationen nach einem erfolgten Einstieg so erzeugt werden, dass der Sendepegel des Gebersignals auf einen Maximalsendepegelwert angehoben oder angepasst wird und von dem Maximalsendepegelwert so weit abgesenkt wird, dass gerade keiner der Sensorpegel mehr ein Erfassen des Betätigungselements in dem überwachten Volumen anzeigt. Hierdurch ist einerseits sichergestellt, dass eine Annäherung zuverlässig erfasst wird, da eine ausreichend hohe Empfindlichkeit aufgrund eines zunächst sehr hohen Sendepegels gewährleistet ist. Ferner wird ein nicht beabsichtigtes Erfassen des Betätigungselements vermieden, indem der Sendepegel so weit abgesenkt wird, dass keiner der Sensorpegel mehr ein Erfassen des Betätigungselements anzeigt. Ein Nichterfassen des Betätigungselements bedeutet in diesem Zusammenhang, dass eine empfangene Signalstärke unterhalb eines vorgegebenen Schwellenwertes liegt.

Besonders vorteilhaft ist es, den Sendepegel des Gebersignals zusätzlich nach dem Absenken auf einen Sendepegelwert, an dem gerade keiner der Sensorpegel mehr ein Erfassen des Betätigungselements anzeigt, um einen vorfestgelegten Wert weiter abzusenken. Hierdurch wird berücksichtigt, dass sich das Betätigungselement direkt nach einem Einstieg in der Regel nicht direkt am Rand des Volumens befindet, innerhalb dessen das Betätigungselement zuverlässig erfasst werden soll. Um somit eine Erfassung außerhalb des gewünschten Volumens zu vermeiden, ist die zusätzliche Absenkung von Vorteil. Dennoch bleibt eine ausreichende Sensitivität des Gesamtsystems gewahrt, da die Absenkung um den vorfestgelegten Wert sicherstellt, dass eine ausreichende Signalstärke vorliegt, um bei einem Eindringen in das zu überwachende Volumen auch tatsächlich ein gewünschter Sensorpegel erzeugt wird.

Die Merkmale des erfindungsgemäßen Verfahrens weisen dieselben Vorteile wie die entsprechenden Merkmale der erfindungsgemäßen Positionsbestimmungseinheit auf.

Nachfolgend wird die Erfindung anhand bevorzugter Ausführungsbeispiele näher erläutert. Hierbei zeigen:
- Fig. 1: eine schematische Ansicht eine Positionsbestimmungseinheit in einem Kraftfahrzeug;
- Fig. 2a, 2b: schematische Ansichten einer als Touchscreen ausgebildeten Anzeigefläche, auf denen entsprechend gewünschte Betätigungsorte für einen Fahrer bzw. einen Beifahrer zum Ausführen der Sendepegelanpassung dargestellt sind;
- Fig. 3a, 3b: weitere schematische Ansichten eines als Touchscreen ausgeführten Bedienelements, auf dem jeweils ein gewünschter Betätigungsort für den Fahrer bzw. Beifahrer zum Ausführen einer Sensorpegelanpassung dargestellt sind; und
- Fig. 4: eine grafische Darstellung des Sendepegels aufgetragen gegen die Zeit.

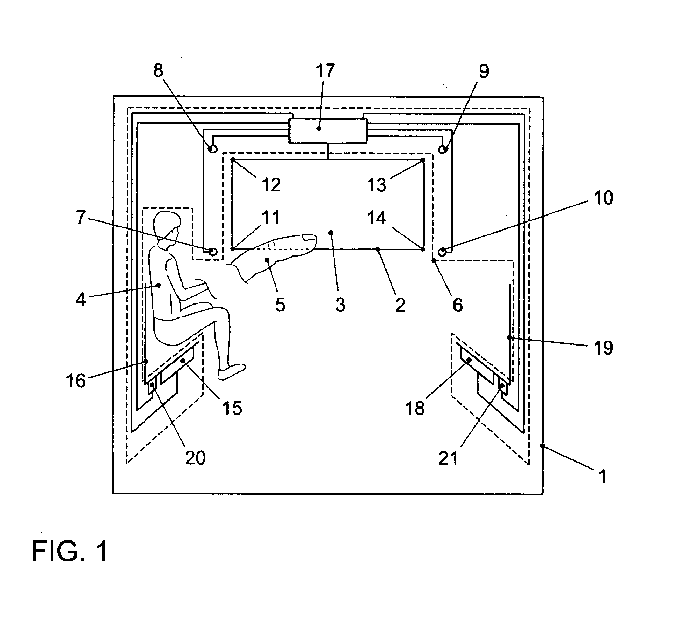

In Fig. 1 ist schematisch ein Innenraum eines Kraftfahrzeug 1 dargestellt. In einer Mittelkonsole ist ein als Touchscreen ausgebildetes Bedienelement 2 angeordnet. Auf einer frei programmierbaren Anzeigefläche 3 können einerseits Informationen für einen Nutzer 4 ausgegeben werden. Andererseits können auf der frei programmierbaren Anzeigefläche so genannte virtuelle Bedienelemente angezeigt werden, die der Nutzer 4 über eine Berührung mit einem Betätigungselement 5 auslösen kann. Das Betätigungselement 5 wird in der Regel ein Finger des Nutzers sein. Um eine Position des Betätigungselements 5 in einem Raumbereich vor dem Bedienelement, d.h. einem überwachten Volumen vor der Anzeigefläche 3, erfassen zu können, ist eine berührungslos messende Positionsbestimmungseinheit 6 vorgesehen. Die Positionsbestimmungseinheit 6 umfasst Sensoren 7-10, die benachbart zu Ecken 11-14 der Anzeigefläche 3 angeordnet sind. Diese Sensoren 7-10 empfangen ein Hochfrequenzsignal, das über den Nutzer 4 und dessen Betätigungselement 5 übertragen wird und in diese kapazitiv eingekoppelt wird. Das übertragene Hochfrequenzsignal, welches Gebersignal genannt wird, wird von einem Signalgeber 15 erzeugt, der in einen Fahrersitz 16 integriert ist. Das mit einem Sendepegel erzeugte Gebersignal wird kapazitiv in den auf dem Fahrersitz 16 sitzenden Nutzer eingekoppelt, über den Körper des Nutzers 4 und dessen Betätigungselement 5 übertragen und kapazitiv in die Sensoren 7-10 eingekoppelt. In Abhängigkeit von der empfangenen Signalstärke stellen diese Sensoren 7-10 ein Signal bereit, das einen Sensorpegel angibt.
Die einzelnen Sensoren 7-10 sind mit einer Steuer- und Auswerteeinheit 17 verbunden, die anhand der Sensorpegel eine Position des Betätigungselements 5 im Raum vor der Anzeigefläche 3 ermittelt. Hierbei wird ausgenutzt, dass die einzelnen Sensorpegel ein Maß für den Abstand des Betätigungselements von dem entsprechenden Sensor 7-10 sind. Die Position kann somit über eine Triangulation bestimmt werden.

Da die Übertragung des Hochfrequenzsignals über den Nutzer 4 und das Betätigungselement 5 von verschiedenen Faktoren, beispielsweise einer Sitzhaltung des Nutzers 4, der getragenen Kleidung, einer Luftfeuchtigkeit der Fahrzeuginnenluft, einer Leitfähigkeit der Haut des Nutzers 4 und des Betätigungselements 5 aufgrund einer Schweißentwicklung usw., abhängig ist, ist die Steuer- und Auswerteeinheit 17 informationstechnisch mit dem Signalgeber 15 verbunden, um den Sendepegel in Abhängigkeit von den Sensorpegeln, die mittels der Sensoren 7-10 erfasst sind, steuern und regeln zu können. Auf diese Weise kann sichergestellt werden, dass einerseits das Betätigungselement 5 zuverlässig beim Eintreten in das Volumen vor der Anzeigefläche erkannt und erfasst wird und andererseits die Sensorpegel in einem vorgegebenen Pegelwertebereich bleiben. Wird das Gebersignal sehr gut in den Nutzer eingekoppelt und sehr gut durch den Nutzer und dessen Betätigungselement 5 übertragen, so kann die empfangene Signalstärke so groß werden, dass ein maximaler Sensorpegelwert von einem der Sensoren bereits erreicht wird, bevor das Betätigungselement einen minimal möglichen Abstand zu diesem Sensor aufweist. In einem solchen Fall gibt es in der Regel einen endlichen Abstand von dem entsprechenden Sensor, dessen Unterschreitung keine Sensorpegeländerung mehr hervorruft. Diese Situation ist unerwünscht, da in einem solchen Fall die Positionsermittlung des Betätigungselements nicht mehr zuverlässig möglich ist. Eine Sendepegelanpassung ist nun erforderlich, die weiter unten ausführlicher erläutert ist.

Um auch ein weiteres Betätigungselement eines weiteren Nutzers, beispielsweise eines Beifahrers, erfassen zu können, umfasst die Positionsbestimmungseinheit 6 der dargestellten Ausführungsform einen weiteren Signalgeber 18, der in den Beifahrersitz 19 integriert ist. Der weitere Signalgeber 18 erzeugt vorzugsweise ein Hochfrequenzsignal, welches eine andere Frequenz aufweist oder ein gegenüber dem Gebersignal unterschiedlich moduliertes Hochfrequenzsignal darstellt.

Der Signalgeber 15 und der weitere Signalgeber 18 können auch an anderen Stellen im Kraftfahrzeug angeordnet sein. Eine kapazitive Einkopplung des Gebersignals bzw. weiteren Gebersignals ist jedoch besonders einfach möglich, indem beispielsweise leitende Matten in die Sitzfläche eingearbeitet werden.

Des Weiteren ist es vorteilhaft, bei manchen Ausführungsformen Sitzbelegungssensoren 20, 21 vorzusehen, die eine Belegung des Sitzes erfassen. Diese müssen nicht notwendigerweise Bestandteile der Positionserfassungseinheit 6 sein.

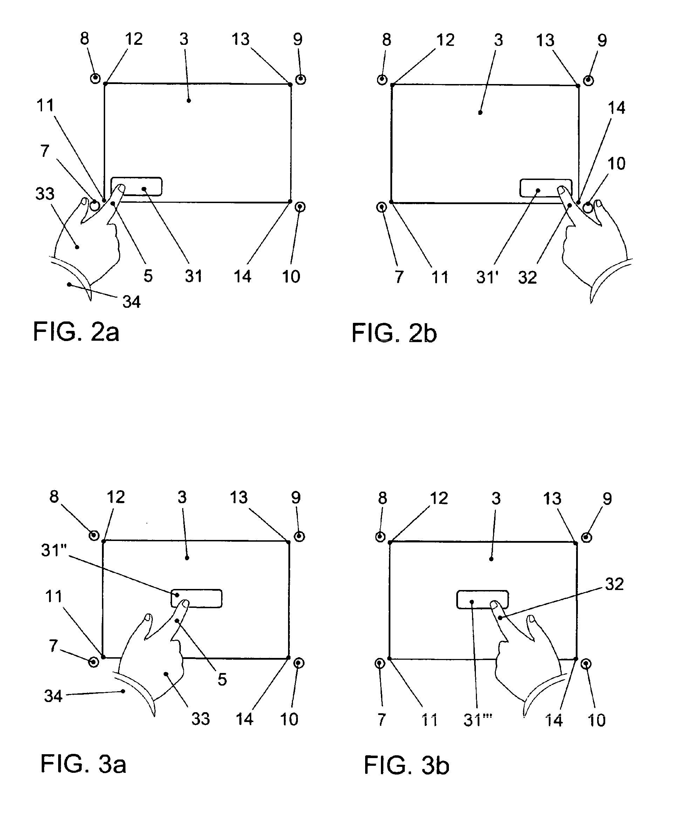

Um den Sensorpegel sinnvoll anzupassen, ist bei einer Ausführungsform der Erfindung vorgesehen, dass der Nutzer aufgefordert wird, das Bedienelement 2 einmalig zu berühren. Bei der in Fig. 1 dargestellten Ausführungsform, bei der das Bedienelement ein Touchscreen ist, kann beispielsweise auf der Anzeigefläche 3 eine Anweisung ausgegeben werden, eine bestimmte Nachricht zu quittieren, indem ein virtuelles Bedienelement, welches als OK-Taster ausgebildet ist, zu betätigen ist. Eine solche Situation ist in Fig. 2a dargestellt. Das virtuelle Bedienelement 31 ist in einer unteren, dem Fahrer zugewandten Ecke auf der Anzeigefläche 3 dargestellt. Berührt der Nutzer das virtuelle Bedienelement 31 mit dem Betätigungselement 5, so befindet sich dieses Betätigungselement 5 in unmittelbarer Nähe des benachbart zu der linken unteren Ecke 11 angeordneten Sensors 7. Dieser sollte optimalerweise somit einen Sensorpegel nahe einem maximalen Sensorpegel erzeugen. Die übrigen Sensoren 8-10 sollten entsprechend geringere Sensorpegel bereitstellen. Ist dieses der Fall, so muss der Sendepegel, den die Gebereinheit erzeugt, nicht angepasst werden. Liegen jedoch die Sensorpegel zu hoch, so muss der Sendepegel des Gebersignals reduziert werden. Liegen hingegen die Sensorpegel alle zu niedrig, so ist der Sendepegel des Gebersignals anzuheben. In der Regel wird eine Reduzierung des Sendepegels begonnen, sobald einer der Sensorpegel eine für den entsprechenden Sensor (8-11) festgelegte Pegelschwelle überschritten hat. Je nach Abstand des virtuellen Bedienelements von den Sensoren können die Pegelschwellen unterschiedlich festgelegt werden. Für den in der unteren linken Ecke 11 angeordneten Sensor 7, der nahe dem virtuellen Bedienelement 31 angeordnet ist, wird die Pegelschwelle vorzugsweise nahe dem maximalen Sensorpegel festgelegt, den der Sensor im Betrieb im Arbeitsbereich erzeugen kann. Die Pegelschwellen der übrigen Sensoren 8-10 werden entsprechend ihres Abstand von dem virtuellen Bedienelement 31 geringer festgelegt. Hierdurch ist sichergestellt, dass der Sensorpegel für diese Sensoren 8-10 steigen können, wenn das Betätigungselement in eine der anderen Ecken 12-14 bewegt wird.

Der Vorteil dieser Anordnung liegt darin, dass die Position des Betätigungselements 5 im Zeitpunkt der Betätigung des virtuellen Bedienelements 31 aufgrund der Darstellungsposition des virtuellen Bedienelements 31 bzw. der von dem Touchscreen ermittelten Berührposition bekannt ist. Zeitlich korreliert mit der Erfassung der Betätigung des Bedienelements 2, d.h. des virtuellen Bedienelements 31, werden die Sensorpegel der einzelnen Sensoren 7-10 erfasst und ausgewertet.

In Fig. 2b ist die entsprechende Situation für den Beifahrer dargestellt. Ein geeigneter Ort für eine Berührung liegt an einer dem Beifahrer zugewandten unteren Ecke der Anzeigefläche 3. Im Zeitpunkt der Berührung des virtuellen Bedienelements 31' ist das weitere Betätigungselement 32 des weiteren Nutzers unmittelbar zu dem Sensor 10 benachbart. Dieser sollte somit einen Sensorpegel nahe einem maximalen Sensorpegel liefern. Die übrigen Sensorpegel der Sensoren 7-9 sollten entsprechend geringer sein. Es ergibt sich für den Fachmann, dass der Sendepegel für das Gebersignal des Signalgebers unabhängig von dem Sendepegel für das weitere Gebersignal des weiteren Signalgebers gewählt werden können.

Fig. 3a und 3b zeigen Ausführungsformen, bei denen das virtuelle Bedienelement 31" für den Fahrer bzw. das virtuelle Bedienelement 31"' für den Beifahrer mittig auf der Anzeigefläche dargestellt sind. Bei einer Berührung der virtuellen Bedienelemente 31", 31"' durch den Fahrer bzw. Beifahrer ist zu erwarten, dass die Sensorpegel der Sensoren 7-10 jeweils ungefähr den gleichen Sensorpegel aufweisen, der einem vorgegebenen Sensorpegelwert entspricht oder in einem vorgegebenen Sensorpegelbereich um diesen vorgegebenen Sensorpegel liegt. Ebenso ist eine Mittelwertbildung vorteilhaft und ein Vergleich des Mittelwerts mit einem Sollmittelwert oder Sollmittelwertbereich. Wie in Fig. 3a dargestellt ist, ist es jedoch möglich, dass die Hand 33 oder ein Unterarm 34 einen der Sensoren, in diesem Fall den in einer unteren linken Ecke angeordneten Sensor 7, überdeckt, so dass dieser kapazitiv stark an den Nutzer ankoppelt. Die empfangene Signalstärke dieses Sensors 7 ist somit sehr hoch, so dass diese häufig nahe dem maximalen Sensorpegel liegen wird. In einem solchen Fall ist es vorteilhaft, nur die Sensorpegel der übrigen Sensoren zu verwenden, um einen Sensorpegelmittelwert zu bilden und diesen mit einem Sollmittelwert bzw. einem Sollmittelwertbereich zu vergleichen und entsprechend Steuersignale für den Signalgeber oder im Falle einer Betätigung durch den Beifahrer für den weiteren Signalgeber zu erzeugen.

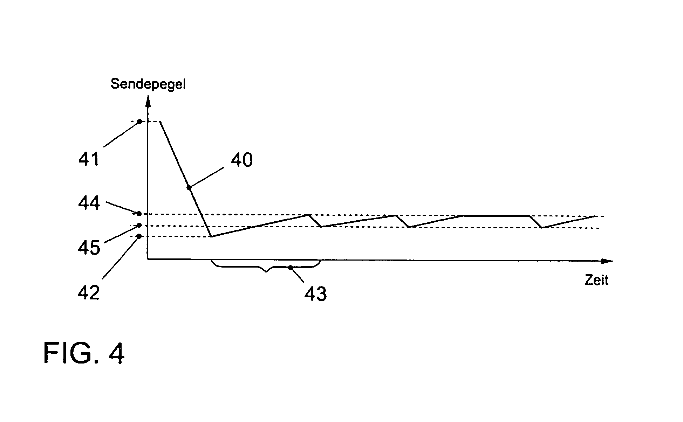

Eine andere Möglichkeit der Sendepegelanpassung soll anhand der Fig. 4 erläutert werden. Dort ist der Sendepegel 40 grafisch gegen die Zeit aufgetragen. Beim Einstieg des Nutzers in das Fahrzeug wird der Sendepegel auf einen Maximalwert 41 gesetzt. Der Einstieg des Nutzers in das Fahrzeug kann beispielsweise mittels eines Sitzbelegungssensors erfasst werden. Sobald eine Annäherung des Betätigungselements des Nutzers an das Bedienelement und/oder einen der Sensoren erfasst wird, steigt dessen Sensorpegel oder der Sensorpegel eines oder aller übrigen Sensoren. Überschreitet einer der Sensorpegelwerte eine Pegelschwelle, so wird der Sendepegel des Gebersignals reduziert, um den Sensorpegel auf der entsprechenden Pegelschwelle zu halten. Bei einem Annähern des Betätigungselements wird somit der Sendepegel kontinuierlich verringert, bis der Benutzer bei einer Betätigung des Bedienelements eine bekannte Entfernung zu einem oder mehreren der Sensoren erreicht hat und sich das System in seinem Arbeitspunkt befindet. Bei dieser Ausführungsform wird somit der Sendepegel kontinuierlich gedämpft, um den Sensorpegel benutzerabhängig in einem geeigneten Bereich zu halten. Liegt der Berührpunkt in der Mitte eines als Touchscreen ausgebildeten Bedienelements, kann eine weitere Reduktion des Sendepegels erforderlich sein, wenn die Pegelschwelle nahe dem maximalen Sensorpegel gewählt sind. Sind die Pegelschwellen für einen Berührpunkt in der Mitte des Touchscreens entsprechend geringer gewählt oder liegt der Berührpunkt nahe einem minimalen Abstand von einem der Sensoren, so ist der Sendepegel für einen optimalen Arbeitsbereich zum Zeitpunkt der Berührung des Touchscreens erreicht.

Um zu verhindern, dass der Sendepegel aufgrund von Störungen, die dazu führen, dass die empfangene Signalstärke kurzzeitig sehr hoch ist, was wiederum zu einem deutlichen Absenken des Sendepegels führt, langfristig zu niedrig bleibt, ist bei der beschriebenen Ausführungsform vorgesehen, dass nach dem Erreichen eines ersten Arbeitspunktsendepegels 42 über einen vorgegebenen Zeitraum 43 der Sendepegel wieder auf einen vorgegebenen Sendepegelschwellenwert 44 oder mit einer vorgegebenen Steigerungsrate auf den Sendepegelschwellenwert 44 angehoben wird. In anderen Ausführungsformen kann eine Erhöhung um eine vorgegebene absolute oder prozentuale Sendepegeldifferenz erfolgen. Bei einer erneuten Annäherung wird der Sendepegel 40 gegebenenfalls erneut kontinuierlich abgesenkt, bis das Betätigungselement einen minimalen Abstand oder einen vorbekannten Abstand zu einem oder mehreren der Sensoren aufweist und ein weiterer Arbeitspunktsendepegel 45 erreicht ist. Dieser Prozess des Absenkens und Anhebens wird kontinuierlich fortgesetzt und sorgt jederzeit für einen optimalen Sendepegel.

Bei wieder einer anderen Ausführungsform kann vorgesehen sein, dass nach dem Einsteigen des Nutzers oder weiteren Nutzers der entsprechende Sensorpegel des Gebersignals oder weiteren Gebersignals zunächst maximal eingestellt wird und anschließend soweit reduziert wird, dass das Betätigungselement oder weitere Betätigungselement gerade von keinem der Sensoren nicht mehr als in dem überwachten Volumen befindlich erkannt werden. Hierbei wird davon ausgegangen, dass unmittelbar nach dem Einstieg sich das Betätigungselement bzw. weitere Betätigungselement noch nicht in dem überwachten Volumen vor dem Bedienelement befindet. In der Regel wird jedoch die Empfindlichkeit der Positionsbestimmungseinheit noch zu noch sein, so dass bei einer Annäherung des Betätigungselements bzw. weiteren Betätigungselements unmittelbar an einen der Sensoren der entsprechende Sensorpegel einen vorgegebenen maximalen Schwellenwert überschreiten wird. Um dies zu verhindern, ist es vorteilhaft, nach einem Absenken des Sendepegels oder weiteren Sendepegels diese um einen weiteren vorgegebenen absoluten oder prozentualen Wert zu reduzieren.

Selbstverständlich ist es möglich, bei einer Ausführungsform die Werte für den Sendepegel benutzerbezogen in einem Speicher abzulegen. Ein Abruf kann beispielsweise gekoppelt an einen nutzerbezogenen Schlüssel erfolgen. Bei solchen Ausführungsformen, bei denen der Sendepegel benutzerabhängig abgespeichert ist, kann es zusätzlich vorteilhaft sein, mehrere Berührpositionen durch das Betätigungselement berühren zu lassen, um einen optimalen Wert für den Sendepegel genauer bestimmen zu können. Hierbei können auch einfache Gesten, die mittels des Betätigungselements ausführbar sind, mit einbezogen werden. Es ergibt sich für den Fachmann, dass das Einbeziehen der Gesten auch in solchen Ausführungsformen stattfinden kann, in denen der Sendepegel nicht nutzerbezogen abgespeichert wird.

Die beschriebenen Ausführungsformen sind lediglich exemplarisch. Beliebige Kombinationen der beschriebenen Merkmale können verwendet werden, um die Erfindung umzusetzen.

### Bezugszeichenliste

- 1: Kraftfahrzeug
- 2: Bedienelement
- 3: Anzeigefläche
- 4: Nutzer
- 5: Betätigungselement
- 6: Positionsbestimmungseinheit
- 7-10: Sensoren
- 11-14: Ecken der Anzeigefläche
- 15: Signalgeber
- 16: Fahrersitz
- 17: Steuer- und Auswerteeinheit
- 18: weiterer Signalgeber
- 19: Beifahrersitz
- 20,21: Sitzbelegungssensoren
- 31, 31', 31", 31"': virtuelles Bedienelement
- 32: weiteres Betätigungselement
- 33: Hand
- 34: Unterarm
- 40: Sendepegel
- 41: Maximalwert
- 42: Arbeitspunktsendepegel
- 43: vorgegebener Zeitraum
- 44: Sendepegelschwellenwert
- 45: weiterer Arbeitspunktsendepegel

## Patentansprüche

1. Berührungslos messende Positionsbestimmungseinheit (6) zum berührungslosen bestimmen einer Position eines Betätigungselements eines Nutzers eines Kraftfahrzeugs. umfassend einen Signalgeber (15; 18), der ausgebildet ist, ein hochfrequentes Gebersignal mit einem Sendepegel zu erzeugen und kapazitiv oder leitend in einen Nutzer (4) einzukoppeln, mehrere zueinander beabstandete Sensoren (7-10), die ausgebildet sind, das über den Nutzer (4) und ein Betätigungselement (5) des Nutzers (4) übertragene Gebersignal kapazitiv zu empfangen, und eine Steuer- und Auswerteeinheit (17), die anhand der von den Einzelnen der mehreren Sensoren (7-10) bereitgestellten Sensorpegeln, die jeweils eine empfangene Gebersignalstärke repräsentieren, unter Berücksichtigung der vorbekannten Positionen der Sensoren (7-10) eine Position des Betätigungselements (5) des Nutzers (4) im Raum bestimmt,
**dadurch gekennzeichnet, dass**
der Signalgeber mit der Steuer- und Auswerteeinheit (17) informationstechnisch gekoppelt ist und ausgebildet ist, den Sendepegel des Gebersignals in Abhängigkeit von von der Steuer- und Auswerteeinheit (17) empfangenen Steuerinformationen anzupassen.

2. Positionsbestimmungseinheit (6) nach Anspruch 1, **dadurch gekennzeichnet, dass** ein Bedienelement (2) mit der Steuer- und Auswerteeinheit (17) gekoppelt ist, mit dem eine Betätigungshandlung des Betätigungselements (5) zeitlich korreliert mit den die empfangenen Gebersignalstärken im Betätigungszeitpunkt repräsentierenden Sensorpegeln erfassbar ist, und die Steuerinformationen aus diesen Sensorpegeln abgeleitet wird.

3. Positionsbestimmungseinheit (6) nach einem der genannten Ansprüche, **dadurch gekennzeichnet, dass** das Bedienelement (2) ein Touchscreen ist, der zusätzlich zu einer Information, die einen Berührzeitpunkt angibt, auch eine Berührpositionsinformation bereitstellt.

4. Positionsbestimmungseinheit (6) nach einem der genannten Ansprüche, **dadurch gekennzeichnet, dass** für jeden Sensor (7-10) eine Pegelschwelle festegelegt ist und Steuerinformationen verändert werden, wenn einer der Sensorpegel die zugehörige Pegelschwelle überschreitet.

5. Positionsbestimmungseinheit (6) nach einem der genannten Ansprüche, **dadurch gekennzeichnet, dass** der Sendepegel bei einer Inbetriebnahme auf einen Maximalsendepegel angepasst wird und die Steuer- und Auswerteeinheit (17) die Steuerinformationen so erzeugt, dass der Sendepegel angepasst wird, um die Sensorpegel innerhalb eines vorfestgelegten Pegelwertebereichs zu halten, während das Betätigungselement (5) erstmals in Berührung mit dem Bedienelement (2) gebracht wird.

6. Positionsbestimmungseinheit (6) nach einem der genannten Ansprüche, **dadurch gekennzeichnet, dass** der Sendepegel des Gebersignals nach einem Berühren des Bedienelements bis zu einem Sendepegelschwellenwert wieder angehoben wird, wenn die Sensorpegelwerte alle außerhalb des vorfestgelegten Pegelwertebereichs liegen und der Sendepegel bei einer erneuten Annäherung erneut abgesenkt wird, sofern dieses erforderlich ist, um die Sensorpegel in dem Pegelwertebereich zu halten.

7. Positionsbestimmungseinheit (6) nach einem der genannten Ansprüche, **dadurch gekennzeichnet, dass** mit der Auswerte- und Steuereinheit Mittel zum Erfassen eines Einstiegs des Nutzers (4) verknüpft sind, und die Steuerinformationen nach einem erfolgten Einstieg so erzeugt werden, dass der Sendepegel des Gebersignals auf einen Maximalpegelwert angepasst wird und dann von einem Maximalsendepegel soweit abgesenkt wird, dass gerade keiner der Sensorpegel mehr ein Erfassen des Betätigungselements (5) in dem überwachten Volumen anzeigt.

8. Verfahren zum berührungslosen Bestimmen einer Position eines Betätigungselements (5) eines Nutzers (4) eines Kraftfahrzeugs im Raum umfassend folgende Schritte:
Erzeugen eines hochfrequenten Gebersignals mit einem Sendepegel mittels eines Signalgebers und kapazitives oder leitendes Einkoppeln des Gebersignals in den Nutzer (4),
Empfangen des über den Nutzer (4) und das Betätigungselement (5) übertragenen und kapazitiv in mehrerer zueinander beabstandet angeordnete Sensoren (7-10) eingekoppelten Gebersignals, wobei jeder Sensor ein einen Sensorpegel repräsentierendes Signal bereitstellt, wobei der Sensorpegel jeweils eine empfangene Gebersignalstärke repräsentiert, und mittels einer Steuer- und Auswerteeinheit (17) anhand der von den mehreren Sensoren (7-10) bereitgestellten Sensorpegeln unter Berücksichtigung der vorbekannten Positionen der Sensoren (7-10) eine Position eines Betätigungselements (5) des Nutzers (4) im Raum ermittelt wird,
**dadurch gekennzeichnet, dass**
die Steuer- und Auswerteeinheit (17) Steuerinformationen zu dem Signalgeber übermittelt und der Signalgeber den Sendepegel des Gebersignals entsprechend der Steuerinformationen anpasst.

9. Verfahren nach Anspruch 8, **dadurch gekennzeichnet, dass** eine Betätigungshandlung des Betätigungselements (5) mittels eines Bedienelements zeitlich korreliert mit den die empfangenen Gebersignalstärken im Betätigungszeitpunkt repräsentierenden Sensorpegeln erfasst wird und die Steuerinformationen aus diesen Sensorpegeln abgeleitet wird.

10. Verfahren nach einem der Ansprüche 8 oder 9, **dadurch gekennzeichnet, dass** das Bedienelement (2) ein Touchscreen ist, der zusätzlich zu einer Information, die eine Berührung und/oder einen Berührzeitpunkt angibt, auch eine Berührpositionsinformation bereitstellt wird.

11. Verfahren nach einem der Ansprüche 8 bis 10, **dadurch gekennzeichnet, dass** für jeden Sensor (7-10) eine Pegelschwelle festegelegt wird und die Steuerinformationen verändert werden, wenn einer der Sensorpegel die zugehörige Pegelschwelle überschreitet.

12. Verfahren nach einem der Ansprüche 8 bis 11, **dadurch gekennzeichnet, dass** der Sendepegel bei einer Inbetriebnahme auf einen Maximalsendepegel angepasst wird und der Sendepegel anschließend, während das Betätigungselement (5) erstmals in Berührung mit dem Bedienelement (2) gebracht wird, so angepasst wird, dass die Sensorpegel innerhalb eines vorfestgelegten Pegelwertebereichs gehalten werden.

13. Verfahren nach einem der Ansprüche 8 bis 12, **dadurch gekennzeichnet, dass** der Sendepegel des Gebersignals nach einem Berühren des Bedienelements über einen vorgegebenen Zeitraum bis zu einem Sendepegelschwellen wieder angehoben wird, wenn die Sensorpegelwerte alle außerhalb des vorfestgelegten Pegelwertebereichs liegen, und der Sendepegel des Gebersignals bei einer erneuten Annäherung erneut abgesenkt wird, sofern dieses erforderlich ist, um die Sensorpegel in dem Pegelwertebereich zu halten.

14. Verfahren nach einem der Ansprüche 8 bis 13, **dadurch gekennzeichnet, dass** ein Einstieg des Nutzers (4) erfasst wird und die Steuerinformationen nach einem erfolgten Einstieg den Sendepegel des Gebersignals einen Maximalsendepegel anpassen und von dem Maximalsendepegel soweit absenken, dass gerade keiner der Sensorpegel mehr ein Erfassen des Betätigungselements (5) in einem zu überwachenden Volumen anzeigt.

15. Verfahren nach Anspruch 14, **dadurch gekennzeichnet, dass** der Sendepegel des Gebersignals zusätzlich nach dem Absenken, so dass gerade keiner der Sensorpegel mehr ein Erfassen des Betätigungselements (5) anzeigt, um einen vorfestgelegten Wert weiter abgesenkt wird.

## Claims

1. Position-determining unit (6) which measures in a contactless manner and is intended to contactlessly determine a position of an operating element associated with a user of a motor vehicle, comprising a signal transmitter (15; 18) which is designed to generate a radio-frequency transmitter signal with a transmission level and to capacitively or conductively couple said signal into a user (4), a plurality of sensors (7-10) which are at a distance from one another and are designed to capacitively receive the transmitter signal transmitted via the user (4) and an operating element (5) associated with the user (4), and a control and evaluation unit (17) which uses the sensor levels which are provided by the individual sensors of the plurality of sensors (7-10) and each represent a received transmitter signal strength to determine a position of the operating element (5) associated with the user (4) in space taking into account the previously known positions of the sensors (7-10),
**characterized in that**
the signal transmitter is coupled to the control and evaluation unit (17) in terms of information and is designed to adjust the transmission level of the transmitter signal on the basis of control information received from the control and evaluation unit (17).

2. Position-determining unit (6) according to Claim 1, **characterized in that** a control element (2) is coupled to the control and evaluation unit (17) and can be used to detect an operating action of the operating element (5) in temporal correlation with the sensor levels which represent the received transmitter signal strengths at the operating time, and the control information is derived from these sensor levels.

3. Position-determining unit (6) according to one of said claims, **characterized in that** the control element (2) is a touch screen which, in addition to an item of information which indicates a touch time, also provides an item of touch position information.

4. Position-determining unit (6) according to one of said claims, **characterized in that** a level threshold is defined for each sensor (7-10), and control information is changed if one of the sensor levels exceeds the associated level threshold.

5. Position-determining unit (6) according to one of said claims, **characterized in that**, upon start-up, the transmission level is adjusted to a maximum transmission level and the control and evaluation unit (17) generates the control information in such a manner that the transmission level is adjusted in order to keep the sensor levels within a predefined level value range, while the operating element (5) is brought into contact with the control element (2) for the first time.

6. Position-determining unit (6) according to one of said claims, **characterized in that** the transmission level of the transmitter signal is increased to a transmission level threshold value again, after the control element has been touched, if the sensor level values are all outside the predefined level value range, and the transmission level is reduced again, in the event of a renewed approach, if this is necessary in order to keep the sensor levels in the level value range.

7. Position-determining unit (6) according to one of said claims, **characterized in that** means for detecting entry of the user (4) are linked to the evaluation and control unit, and the control information is generated, after entry, in such a manner that the transmission level of the transmitter signal is adjusted to a maximum level value and is then reduced from a maximum transmission level to such an extent that none of the sensor levels currently still indicate detection of the operating element (5) in the volume being monitored.

8. Method for contactlessly determining a position of an operating element (5) associated with a user (4) of a motor vehicle in space, comprising the following steps:
a signal transmitter is used to generate a radio-frequency transmitter signal with a transmission level and the transmitter signal is capacitively or conductively coupled into the user (4),
the transmitter signal which is transmitted via the user (4) and the operating element (5) and is capacitively coupled into a plurality of sensors (7-10) which are arranged at a distance from one another is received, each sensor providing a signal which represents a sensor level, the sensor level respectively representing a received transmitter signal strength, and a position of an operating element (5) associated with the user (4) in space being determined using a control and evaluation unit (17) on the basis of the sensor levels provided by the plurality of sensors (7-10) and taking into account the previously known positions of the sensors (7-10),
**characterized in that**
the control and evaluation unit (17) transmits control information to the signal transmitter, and
the signal transmitter adjusts the transmission level of the transmitter signal according to the control information.

9. Method according to Claim 8, **characterized in that** a control element is used to detect an operating action of the operating element (5) in temporal correlation with the sensor levels which represent the received transmitter signal strengths at the operating time, and the control information is derived from these sensor levels.

10. Method according to either of Claims 8 and 9, **characterized in that** the control element (2) is a touch screen which, in addition to an item of information which indicates touch and/or a touch time, also provides an item of touch position information.

11. Method according to one of Claims 8 to 10, **characterized in that** a level threshold is defined for each sensor (7-10), and the control information is changed if one of the sensor levels exceeds the associated level threshold.

12. Method according to one of Claims 8 to 11, **characterized in that**, upon start-up, the transmission level is adjusted to a maximum transmission level and the transmission level is then adjusted, while the operating element (5) is brought into contact with the control element (2) for the first time, in such a manner that the sensor levels are kept within a predefined level value range.

13. Method according to one of Claims 8 to 12, **characterized in that** the transmission level of the transmitter signal is increased to a transmission level threshold again over a predefined period of time, after the control element has been touched, if the sensor level values are all outside the predefined level value range, and the transmission level of the transmitter signal is reduced again, in the event of a renewed approach, if this is necessary in order to keep the sensor levels in the level value range.

14. Method according to one of Claims 8 to 13, **characterized in that** entry of the user (4) is detected, and, after entry, the control information adjusts the transmission level of the transmitter signal to a maximum transmission level and reduces the transmission level from the maximum transmission level to such an extent that none of the sensor levels currently still indicate detection of the operating element (5) in a volume to be monitored.

15. Method according to Claim 14, **characterized in that** the transmission level of the transmitter signal is additionally reduced further by a predefined value after it has been lowered so that none of the sensor levels currently still indicate detection of the operating element (5).

## Revendications

1. Unité de détermination de position (6) à mesure sans contact destinée à la détermination sans contact d'une position d'un élément d'actionnement d'un utilisateur d'un véhicule automobile, comprenant un codeur de signal (15, 18) qui est configuré pour générer un signal de codeur à haute fréquence avec un niveau d'émission et l'injecter de manière capacitive ou par conduction dans un utilisateur (4), plusieurs capteurs (7-10) espacés les uns des autres qui sont configurés pour la réception capacitive d'un signal de codeur transmis par le biais de l'utilisateur (4) et d'un élément d'actionnement (5) de l'utilisateur (4), et une unité de contrôle et d'interprétation (17) qui, au moyen des niveaux de capteur délivrés par les capteurs individuels parmi la pluralité de capteurs (7-10), lesquels représentent respectivement une intensité de signal de codeur reçue, détermine une position de l'élément d'actionnement (5) de l'utilisateur (4) dans l'espace en tenant compte des positions connues à l'avance des capteurs (7-10),
**caractérisée en ce que**
le codeur de signal est connecté informatiquement avec l'unité de contrôle et d'interprétation (17) et il est configuré pour adapter le niveau d'émission du signal de codeur en fonction des informations de commande reçues par l'unité de contrôle et d'interprétation (17).

2. Unité de détermination de position (6) selon la revendication 1, **caractérisée en ce qu'**un élément de commande (2) est connecté à l'unité de contrôle et d'interprétation (17), avec lequel une manipulation d'actionnement de l'élément d'actionnement (5) peut être détectée avec corrélation dans le temps avec les niveaux de capteur représentant les intensités de signal de codeur reçues au moment de l'actionnement, et les informations de commande sont dérivées de ces niveaux de capteur.

3. Unité de détermination de position (6) selon l'une des revendications mentionnées, **caractérisée en ce que** l'élément de commande (2) est un écran tactile qui, en plus d'une information qui indique un moment de contact, délivre également une information de position de contact.

4. Unité de détermination de position (6) selon l'une des revendications mentionnées, **caractérisée en ce qu'**un seuil de niveau est fixé pour chaque capteur (7-10) et des informations de commande sont modifiées lorsque l'un des niveaux de capteur devient supérieur au seul de niveau associé.

5. Unité de détermination de position (6) selon l'une des revendications mentionnées, **caractérisée en ce que** lors d'une mise en service, le niveau d'émission est ajusté à un niveau d'émission maximum et l'unité de contrôle et d'interprétation (17) génère les informations de commande de telle sorte que le niveau d'émission est adapté pour maintenir le niveau de capteur à l'intérieur d'une plage de valeurs de niveau prédéfinie pendant que l'élément d'actionnement (5) est amené en contact pour la première fois avec l'élément de commande (2).

6. Unité de détermination de position (6) selon l'une des revendications mentionnées, **caractérisée en ce que** le niveau d'émission du signal de codeur, après un contact de l'élément de commande, est de nouveau élevé jusqu'à une une valeur de seuil de niveau d'émission lorsque les valeurs de niveau de capteur se trouvent toutes en-dehors de la plage de valeurs de niveau prédéfinie et le niveau d'émission est de nouveau abaissé lors d'une nouvelle approche, sous réserve que cela soit nécessaire pour maintenir le niveau de capteur dans la plage de valeurs de niveau.

7. Unité de détermination de position (6) selon l'une des revendications mentionnées, **caractérisée en ce que** des moyens de détection d'une entrée de l'utilisateur (4) sont combinés avec l'unité de contrôle et d'interprétation et les informations de commande, après qu'une entrée ait eu lieu, sont générées de telle sorte que le niveau d'émission du signal de codeur est ajusté à une valeur de niveau maximum et ensuite abaissé à partir d'un niveau d'émission maximum jusqu'à ce qu'aucun des niveaux de capteur n'indique plus une détection de l'élément d'actionnement (5) dans le volume surveillé.

8. Procédé de détermination sans contact de la position d'un élément d'actionnement (5) d'un utilisateur (4) d'un véhicule automobile dans l'espace, comprenant les étapes suivantes :
génération d'un signal de codeur à haute fréquence avec un niveau d'émission au moyen d'un codeur de signal et injection capacitive ou par conduction du signal de codeur dans l'utilisateur (4),
réception du signal de codeur transmis par le biais de l'utilisateur (4) et de l'élément d'actionnement (5) et injecté de manière capacité dans plusieurs capteurs (7-10) espacés les uns des autres, chaque capteur délivrant un signal représentant un niveau de capteur,
le niveau de capteur représentant à chaque fois une intensité de signal de codeur reçue, et une position d'un élément d'actionnement (5) de l'utilisateur (4) dans l'espace étant déterminée au moyen d'une unité de contrôle et d'interprétation (17) à l'aide des niveaux de capteur délivrés par les plusieurs capteurs (7-10) en tenant compte des positions connues à l'avance des capteurs (7-10),
**caractérisé en ce que**
l'unité de contrôle et d'interprétation (17) communique des informations de commande au codeur de signal et le codeur de signal adapte le niveau d'émission du signal de codeur en fonction des informations de commande.

9. Procédé selon la revendication 8, **caractérisé en ce qu'**une manipulation d'actionnement de l'élément d'actionnement (5) au moyen d'un élément de commande est détectée avec corrélation dans le temps avec les niveaux de capteur représentant les intensités de signal de codeur reçues au moment de l'actionnement, et les informations de commande sont dérivées de ces niveaux de capteur.

10. Procédé selon l'une des revendications 8 ou 9, **caractérisé en ce que** l'élément de commande (2) est un écran tactile qui, en plus d'une information qui indique un contact et/ou moment de contact, délivre également une information de position de contact.

11. Procédé selon l'une des revendications 8 à 10, **caractérisé en ce qu'**un seuil de niveau est fixé pour chaque capteur (7-10) et les informations de commande sont modifiées lorsque l'un des niveaux de capteur devient supérieur au seul de niveau associé.

12. Procédé selon l'une des revendications 8 à 11, **caractérisé en ce que** lors d'une mise en service, le niveau d'émission est ajusté à un niveau d'émission maximum et le niveau d'émission est ensuite adapté, pendant que l'élément d'actionnement (5) est amené en contact pour la première fois avec l'élément de commande (2), de telle sorte que le niveau de capteur est maintenu à l'intérieur d'une plage de valeurs de niveau prédéfinie.

13. Procédé selon l'une des revendications 8 à 12, **caractérisé en ce que** le niveau d'émission du signal de codeur, après un contact de l'élément de commande, est de nouveau élevé jusqu'à un seuil de niveau d'émission pendant une période prédéfinie lorsque les valeurs de niveau de capteur se trouvent toutes en-dehors de la plage de valeurs de niveau prédéfinie et le niveau d'émission du signal de codeur est de nouveau abaissé lors d'une nouvelle approche, sous réserve que cela soit nécessaire pour maintenir le niveau de capteur dans la plage de valeurs de niveau.

14. Procédé selon l'une des revendications 8 à 13, **caractérisé en ce qu'**une entrée de l'utilisateur (4) est détectée et les informations de commande, après qu'une entrée ait eu lieu, ajustent le niveau d'émission du signal de codeur à un niveau d'émission maximum et l'abaissent à partir du niveau d'émission maximum jusqu'à ce qu'aucun des niveaux de capteur n'indique plus une détection de l'élément d'actionnement (5) dans un volume à surveiller.

15. Procédé selon la revendication 14, **caractérisé en ce que** le niveau d'émission du signal de codeur, en plus d'avoir été abaissé de telle sorte qu'aucun des niveaux de capteur n'indique plus une détection de l'élément d'actionnement (5), est abaissé en plus d'une valeur prédéfinie.
